# EUROPEAN PATENT APPLICATION

(11) **EP 4 560 053 A1**
(43) Date of publication of application: **28.05.2025**
(21) Application number: 23859427.9
(22) Date of filing: 30.08.2023
(51) Int. Cl.: C25D 3/38, C08G 65/334, H01L 21/08

(54) **COMPOSITION AND USE THEREOF, LEVELING AGENT, AND PREPARATION METHOD**

(30) Priority: 31.08.2022 CN 202211056305
(71) Applicant: Huawei Technologies Co., Ltd., Shenzhen, Guangdong 518129 (CN)
(72) Inventor: ZHENG, Li, Shenzhen, Guangdong 518129 (CN); HAN, Zuoyan, Shenzhen, Guangdong 518129 (CN); XIAO, Ning, Beijing 100029 (CN); DING, Shengtao, Beijing 100029 (CN)
(74) Representative: MERH-IP Matias Erny Reichl Hoffmann Patentanwälte PartG mbB
(86) International application number: PCT/CN2023/115957
(87) International publication number: WO 2024/046398

(57) **Abstract**

A composition is provided. The composition includes a metal ion source and a leveling agent shown in Formula (I): R₁-S-(R₃-O)ₘ-(R₂-O)ₙ-R₂-(O-R₃)ₘ-S-R₁. In Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2. The composition is applied to metal filling of a through hole on an electronic substrate, to uniformly fill through holes with different apertures, and lower a thickness of a surface metal layer and a dimple value.

## Description

This application claims priority to Chinese Patent Application No. 202211056305.5, filed with the China National Intellectual Property Administration on August 31, 2022 and entitled "COMPOSITION AND APPLICATION THEREOF, AND LEVELING AGENT AND PREPARATION METHOD THEREOF", which is incorporated herein by reference in its entirety.

### TECHNICAL FIELD

Embodiments of this application relate to the field of metal electroplating technologies, and in particular, to a composition and application thereof, and a leveling agent and preparation method thereof.

### BACKGROUND

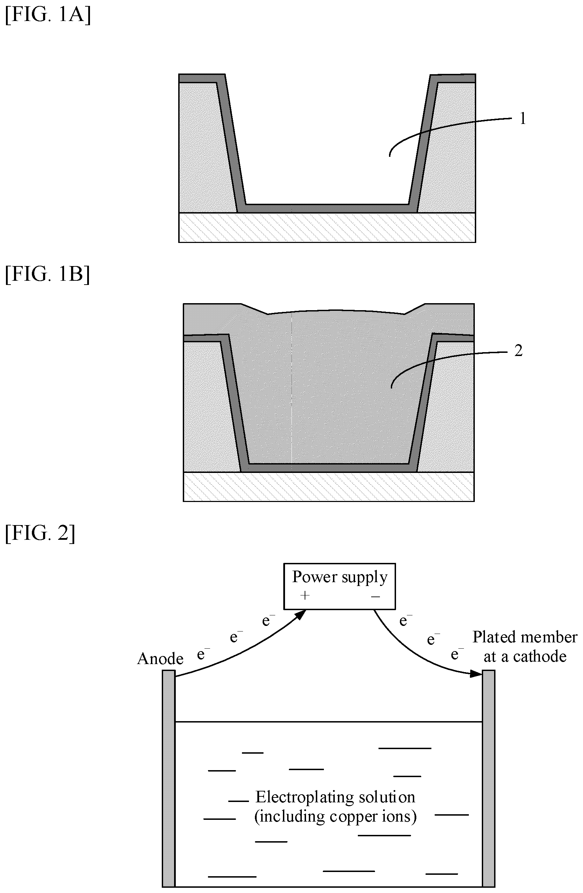

Electronic substrates include common substrates, printed circuit boards, package substrates, and the like. The package substrate is a core material for packaging a chip, and may provide functions such as electrical connection, support and protection, signal distribution, and heat dissipation for the chip. A through hole (including a plated through hole, a blind via hole, and a buried via hole) is a most typical interconnection structure of the package substrate. A copper electroplating technology can implement filling or shape-preserving deposition of interconnection structures such as the plated through hole, the blind via hole, and the buried via hole, and obtain a high-quality electroplated copper layer, to meet a requirement for electrical interconnection of the package substrate. FIG. 1A and FIG. 1B respectively show a blind via hole that is not filled with copper and a blind via hole that is filled with copper, where 1 is the blind via hole.

The electroplated copper layer provides an electrical connection channel for the package substrate, and copper electroplating is a key process for manufacturing the package substrate. To ensure interconnection reliability and a product yield rate, and meet a process requirement of a fine line, the following requirements need to be met to fill the plated through hole, the blind via hole, and the buried via hole through copper electroplating: (1) a small copper-plated thickness, where the small copper-plated thickness can facilitate formation of the fine line, and effectively shorten electroplating time, to improve production efficiency; (2) a capability of deposition of different apertures, for example, deposition of a small hole with a high aspect ratio (aspect ratio> 1) and a large hole (an aperture ranges from 125 µm to 150 µm); and (3) a small dimple (dimple) value, high hole filling rate and electroplating uniformity (>90%), and a few impurities at a plated layer.

To better meet the foregoing technical requirements, an electroplating formula is usually improved in the industry, and a leveling agent is considered as a key factor for improvement.

### SUMMARY

In view of this, embodiments of this application provide a composition. The composition includes a leveling agent with a special structure, and the composition is used to fill an interconnection structure in an electronic substrate, to better implement uniform filling of through holes with different apertures, and lower a thickness of a surface metal layer and a dimple (dimple) value. This can improve interconnection reliability and a yield rate of an electronic product.

Specifically, a first aspect of embodiments of this application provides a composition. The composition is an electroplated composition, and the electroplated composition includes a metal ion source and a leveling agent shown in Formula (I):

R₁-S-(R₃-O)ₘ-(R₂-O)ₙ-R₂-(O-R₃)ₘ-S-R₁ Formula (I).

In Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2.

The electroplated composition provided in embodiments of this application includes a leveling agent with a specific structure. The leveling agent has an ether oxygen chain: (R₃-O)ₘ-(R₂-O)ₙ-R₂-(O-R₃)ₘ and the nitrogen-containing heterocyclic groups connected to two ends of the ether oxygen chain via sulfur bonds. The electroplated composition including the leveling agent with the specific structure is used as electroplated metal to fill a through hole of an electronic substrate. Because the leveling agent can be selectively adsorbed in an area with high current density, current density distribution on a cathode surface in an electroplating process is better adjusted. In addition, the leveling agent has convection dependence, and has high concentration in an area with high convection intensity. Finally, metal deposition in an area corresponding to high current density can be effectively suppressed, to obtain a uniform metal plated layer. In this application, the electroplated composition including the leveling agent with the specific structure can implement simultaneous filling of through holes with different apertures, lower a copper-plated thickness and a dimple value, and improve electroplating uniformity of the entire electronic substrate. In this way, this facilitates manufacturing of a fine line, helps improve reliability of an electronic product, and better meets a manufacturing requirement of a high-density interconnected electronic substrate by using a simple process with low costs. In addition, a molecular structure of the leveling agent is stable, to facilitate a decrease in impurity content of the metal plated layer. In addition, the leveling agent may be prepared by using a simple raw material and process.

In an implementation of this application, the substituted or unsubstituted nitrogen-containing heterocyclic group includes any one of a substituted or unsubstituted pyrrole group, a substituted or unsubstituted imidazole group, a substituted or unsubstituted pyridine group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group. The substituted or unsubstituted nitrogen-containing heterocyclic group is beneficial for the leveling agent to obtain good leveling performance.

In an implementation of this application, a substituted group in the substituted nitrogen-containing heterocyclic group includes one or more of unsubstituted alkyl, haloalkanes, substituted or unsubstituted aryl, substituted or unsubstituted alkoxy, substituted or unsubstituted aryloxy, sulfur, mercapto, hydroxyl, carboxyl, amino, and amide.

In an implementation of this application, the two pieces of R₂ are independently substituted or unsubstituted chain alkylene with carbon atom numbers ranging from 2 to 10, and the two pieces of R₃ are independently substituted or unsubstituted chain alkylene with carbon atom numbers ranging from 2 to 10.

In an implementation of this application, the substituted chain alkylene includes chain alkylene substituted by hydroxyl.

In an implementation of this application, in the electroplated composition, concentration of the leveling agent shown in Formula (I) ranges from 0.01 ppm to 1000 ppm. The concentration of the leveling agent in the electroplated composition is controlled to be within a proper range, to help obtain a moderate deposition speed, better implement simultaneous filling of through holes with different apertures, lower a thickness of a surface metal layer and a dimple value, and improve electroplating uniformity of the entire electronic substrate. In this way, this facilitates manufacturing of the fine line, and helps improve reliability of the electronic product.

In an implementation of this application, the electroplated composition further includes at least one acid, and the at least one acid includes one or more of sulphuric acid and methanesulfonic acid.

In an implementation of this application, concentration of the at least one acid in the electroplated composition ranges from 1 g/L to 300 g/L. A proper acid system and proper acid concentration help obtain a proper electroplating deposition rate.

In an implementation of this application, the electroplated composition further includes one or more of an accelerator, an inhibitor, and an inorganic additive. The leveling agent, the accelerator, the inhibitor, and the inorganic additive cooperate with each other, to better fill the through holes with different apertures simultaneously, and lower the thickness of the surface metal layer and the dimple value.

In an implementation of this application, the accelerator includes one or more of sodium 3-mercapto-1-propanesulfonate (MPS), sodium polyanethol sulfonate (SPS), and N,N-dimethyl-dithioformamide sodium propylene sulfonate (DPS), and concentration of the accelerator in the electroplated composition ranges from 0.01 ppm to 500 ppm. The addition of the accelerator can achieve depolarization effect, to accelerate metal deposition and refine grains at the metal layer.

In an implementation of this application, the inhibitor includes one or more of polyethylene glycol (PEG), polypropylene glycol (PPG), a block copolymer PEO-PPO-PEO, a block copolymer PPO-PEO-PPO, a random copolymer of EO and PO, and propylene glycol block polyether, and concentration of the inhibitor in the electroplated composition ranges from 1 ppm to 2000 ppm. The addition of the inhibitor can inhibit a growth rate of surface metal, and help obtain a thin surface metal layer after electroplating is completed.

In an implementation of this application, the inorganic additive includes a chlorine anion, and concentration of the chlorine anion in the electroplated composition ranges from 0.1 ppm to 100 ppm. The addition of the chloride ion can make plated crystal dense and fine.

In an implementation of this application, the metal ion source includes any one of a copper ion source, a nickel ion source, a tin ion source, a cobalt ion source, a ruthenium ion source, and a silver ion source. It may be understood that, if a metal layer is pre-deposited, the metal ion source in the electroplated composition correspondingly includes a metal ion source corresponding to a metal element at the pre-deposited metal layer. For example, if a metal copper layer is pre-deposited, the metal ion source includes a copper ion source.

In an implementation of this application, the copper ion source includes one or more of copper sulfate pentahydrate and copper methane sulfonate, and in terms of copper ions, concentration of the copper ion source in the electroplated composition ranges from 1 g/L to 120 g/L. The concentration of the copper ion source is controlled within a proper range, to help balance a deposition speed and brightness and flatness of the obtained copper plated layer.

A second aspect of embodiments of this application provides application of the electroplated composition in the first aspect to electroplated metal.

In an implementation of this application, the electroplated metal includes any one of electroplated copper and copper alloy, electroplated nickel and nickel alloy, electroplated tin and tin alloy, electroplated cobalt and cobalt alloy, electroplated ruthenium and ruthenium alloy, and electroplated silver and silver alloy.

In an implementation of this application, the electroplated metal includes metal electroplated in a through hole on an electronic substrate, to implement metal filling.

A third aspect of embodiments of this application provides application of the compound shown in Formula (I) to electroplated metal, where

R₁-S-(R₃-O)ₘ-(R₂-O)ₙ-R₂-(O-R₃)ₘ-S-R₁ Formula (I).

In Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2.

In an implementation of this application, the substituted or unsubstituted nitrogen-containing heterocyclic group includes any one of a substituted or unsubstituted pyrrole group, a substituted or unsubstituted imidazole group, a substituted or unsubstituted pyridine group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group.

In an implementation of this application, a substituted group in the substituted nitrogen-containing heterocyclic group includes one or more of unsubstituted alkyl, haloalkanes, substituted or unsubstituted aryl, substituted or unsubstituted alkoxy, substituted or unsubstituted aryloxy, sulfur, mercapto, hydroxyl, carboxyl, amino, and amide.

In an implementation of this application, the two pieces of R₂ are independently substituted or unsubstituted chain alkylene with carbon atom numbers ranging from 2 to 10, and the two pieces of R₃ are independently substituted or unsubstituted chain alkylene with carbon atom numbers ranging from 2 to 10.

In an implementation of this application, the substituted chain alkylene includes chain alkylene substituted by hydroxyl.

A fourth aspect of embodiments of this application provides a leveling agent. The leveling agent has a general structure formula shown in Formula (II):

R₁-S-(R₃-O)ₘ-(R₂-O)ₙ-R₂-(O-R₃)ₘ-S-R₁ Formula (II).

In Formula (II), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2;

when m=0, the substituted or unsubstituted nitrogen-containing heterocyclic group includes any one of a substituted or unsubstituted pyrrole group, a substituted or unsubstituted pyrimidine group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group;

when m=1, the substituted or unsubstituted nitrogen-containing heterocyclic group includes any one of a substituted or unsubstituted pyrrole group, a substituted or unsubstituted imidazole group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group; and

a substituted group in the substituted nitrogen-containing heterocyclic group includes one or more of unsubstituted alkyl, haloalkanes, substituted or unsubstituted alkoxy, substituted or unsubstituted aryloxy, sulfur, mercapto, hydroxyl, carboxyl, amino, and amide.

In an implementation of this application, in Formula (II), the two pieces of R₂ are independently substituted or unsubstituted chain alkylene with carbon atom numbers ranging from 2 to 10, and the two pieces of R₃ are independently substituted or unsubstituted chain alkylene with carbon atom numbers ranging from 2 to 10.

In an implementation of this application, the substituted chain alkylene includes chain alkylene substituted by hydroxyl.

A fifth aspect of embodiments of this application provides a preparation method for the leveling agent in the fourth aspect. The method includes:

substituting a p-toluene sulfonyl group or an epoxy group for a compound A: OH-(R₂-O)ₙ-R₂-OH, and then reacting, by the compound A, with a nitrogen-containing heterocyclic compound containing mercapto or a carbon-sulfur double bond, to obtain the leveling agent, where in the compound A, two pieces of R₂ are independently substituted or unsubstituted chain alkylene, and n is an integer greater than or equal to 2.

A sixth aspect of embodiments of this application provides an electroplated composition, including the leveling agent in the fourth aspect in embodiments of this application.

A seventh aspect of embodiments of this application provides application of the leveling agent in the fourth aspect or the electroplated composition in the sixth aspect to a metal electroplating process.

In an implementation of this application, an electroplated metal includes any one of electroplated copper and copper alloy, electroplated nickel and nickel alloy, electroplated tin and tin alloy, electroplated cobalt and cobalt alloy, electroplated ruthenium and ruthenium alloy, and electroplated silver and silver alloy.

In an implementation of this application, the electroplated metal includes metal electroplated in a through hole on an electronic substrate, to implement metal filling.

An eighth aspect of embodiments of this application provides a metal electroplating method, including the following steps:

contacting a to-be-electroplated substrate with the electroplated composition in the first aspect or the electroplated composition in the sixth aspect, and applying a current to the to-be-electroplated substrate for electroplating, so that a metal layer is formed on the to-be-electroplated substrate.

In an implementation of this application, the to-be-electroplated substrate is provided with a through hole, and the metal layer includes an intra-hole filling layer filling the through hole and a surface deposition layer deposited around the through hole.

In an implementation of this application, a diameter of the through hole ranges from 10 µm to 200 µm, and a depth ranges from 20 µm to 200 µm.

In an implementation of this application, a process condition of the electroplating is as follows: an electroplating temperature ranges from 10°C to 40°C, a current density ranges from 0.5 ASD to 5 ASD, and electroplating time ranges from 30 min to 300 min.

A ninth aspect of embodiments of this application further provides an electronic substrate, including a substrate layer and a metal layer disposed at the substrate layer. The metal layer is formed by electroplating the electroplated composition in the first aspect or the electroplated composition in the sixth aspect in embodiments of this application, or formed by using the metal electroplating method in the eighth aspect in embodiments of this application.

An embodiment of this application further provides an electronic apparatus. The electronic apparatus uses the electronic substrate in the ninth aspect in embodiments of this application.

### BRIEF DESCRIPTION OF DRAWINGS

FIG. 1A and FIG. 1B respectively show a blind via hole that is not filled with copper and a blind via hole that is filled with copper;
FIG. 2 is a diagram of electroplated copper;
FIG. 3 is a diagram of a dimple (dimple) value;
FIG. 4 is a diagram of a structure of an electronic substrate 100 according to an embodiment of this application;
FIG. 5 shows a hydrogen nuclear magnetic resonance spectrum of a prepared leveling agent 1 according to Embodiment 1 of this application;
FIG. 6 shows a hydrogen nuclear magnetic resonance spectrum of a prepared leveling agent 1 according to Embodiment 1 of this application;
FIG. 7 shows a carbon nuclear magnetic resonance spectrum of a prepared leveling agent 1 according to Embodiment 1 of this application;
FIG. 8 shows linear sweep voltammetry curves of a leveling agent 1, a leveling agent 2, and a leveling agent 3;
FIG. 9 shows cyclic voltammetry curves of a leveling agent 1, a leveling agent 2, and a leveling agent 3;
FIG. 10A, FIG. 10B, FIG. 10C, and FIG. 10D respectively show results of filling, through electroplating, blind via holes with apertures of 80 µm, 100 µm, 125 µm, and 150 µm by using a copper electroplating solution in Embodiment 1;
FIG. 11A, FIG. 11B, FIG. 11C, and FIG. 11D respectively show results of filling, through electroplating, blind via holes with apertures of 80 µm, 100 µm, 125 µm, and 150 µm by using a copper electroplating solution in Embodiment 2;
FIG. 12A, FIG. 12B, FIG. 12C, and FIG. 12D respectively show results of filling, through electroplating, blind via holes with apertures of 80 µm, 100 µm, 125 µm, and 150 µm by using a copper electroplating solution in a comparative example 1;
FIG. 13A, FIG. 13B, FIG. 13C, and FIG. 13D respectively show results of filling, through electroplating, blind via holes with apertures of 80 µm, 100 µm, 125 µm, and 150 µm by using a copper electroplating solution in a comparative example 2; and
FIG. 14A, FIG. 14B, FIG. 14C, and FIG. 14D respectively show results of filling, through electroplating, blind via holes with apertures of 80 µm, 100 µm, 125 µm, and 150 µm by using a copper electroplating solution in a comparative example 3.

### DESCRIPTION OF EMBODIMENTS

The following describes embodiments of this application with reference to accompanying drawings in embodiments of this application.

Electronic substrates include common substrates, printed circuit boards, package substrates, and the like. The package substrate is a core material for packaging a chip, and may provide functions such as electrical connection, support and protection, signal distribution, and heat dissipation for the chip. A through hole (including a plated through hole, a blind via hole, and a buried via hole) is a most typical interconnection structure of the package substrate. A copper electroplating technology can implement filling or shape-preserving deposition of interconnection structures such as the plated through hole, the blind via hole, and the buried via hole, and obtain a high-quality electroplated copper layer, to meet a requirement for electrical interconnection of the package substrate.

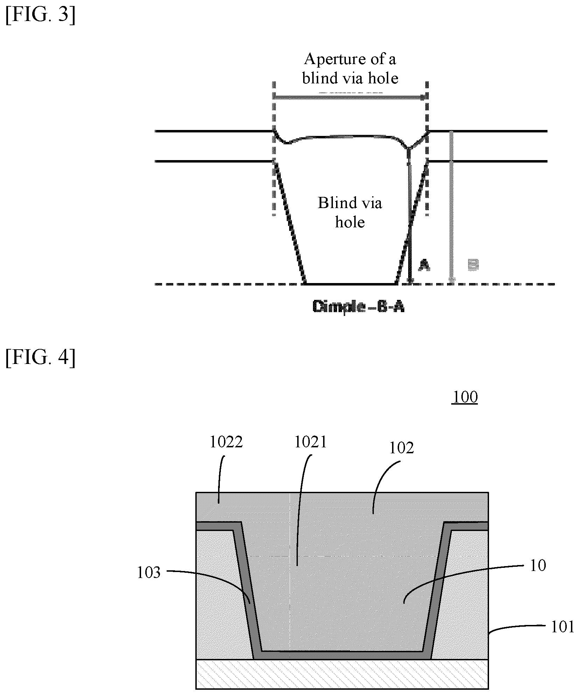

Electroplating is a method of reducing metal ions to metal by using an electrochemical method, and depositing the metal on a surface of a metal or non-metallic product, to form a smooth and dense metal-plated layer that meets a requirement. Electroplating is to use a conductive base as a cathode, and metal is obtained through a reduction reaction and is deposited on a surface of the conductive substrate (the cathode is an electrode that obtains electrons, that is, an electrode at which the reduction reaction occurs); and metal dissolution or an oxygen evolution reaction occurs at a soluble or insoluble anode (the anode is an electrode that can enable an electrolyte to perform an oxidation reaction), and an electroplating solution is used as a conductive loop of the electrolyte. FIG. 2 is a diagram of electroplated copper. In a copper electroplating technology for a package substrate, a cathode-plated member is a to-be-electroplated package substrate. Conductive metal copper is deposited into a required interconnection structure through a metal deposition reaction at the cathode. However, in a process of metal electrodeposition, the to-be-electroplated package substrate at the cathode is usually an irregular plated member, and various interconnection structures with different apertures are further disposed based on requirements. According to a rule of initial current density distribution, an area (for example, the bottom of the blind via hole) whose geometric distance is farther away from an anode has a lower current density, and an area (for example, the top of the blind via hole) whose geometric distance is closer to the anode has a higher current density. In this case, non-uniform filling of the interconnection structure is caused due to a current density difference, it is difficult to obtain a uniform metal plated layer and maintain a low dimple (dimple) value, and even some interconnection structures cannot be filled. As shown in FIG. 3, a dimple (dimple) value = B - A, where B is a distance between an upper surface of the copper surface and the bottom of the blind via hole, and A is a distance between a bottom of a dimple and the bottom of the blind via hole. An embodiment of this application provides an electroplated composition, to form a uniform plated layer and obtain a super-filling or shape-preserving filling structure in an interconnection structure through deposition. The electroplated composition includes a leveling agent with a specific structure, addition of the leveling agent helps improve electroplating uniformity of an entire electronic substrate, can fill through holes with different aspect ratios, and can lower a thickness of a surface metal layer and a dimple (dimple) value.

The electroplated composition provided in embodiments of this application may be used as an electroplating solution for obtaining a metal layer through electroplating deposition. The electroplated composition includes a metal ion source and a leveling agent shown in Formula (I):

R₁-S-(R₃-O)ₘ-(R₂-O)ₙ-R₂-(O-R₃)ₘ-S-R₁ Formula (I).

In Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2.

The electroplated composition provided in embodiments of this application includes a leveling agent with a specific structure shown in Formula (I). The leveling agent has an ether oxygen chain: (R₃-O)ₘ-(R₂-O)ₙ-R₂-(OR₃)ₘ and the nitrogen-containing heterocyclic groups connected to two ends of the ether oxygen chain via sulfur bonds. The electroplated composition including the leveling agent with the specific structure is used as electroplated metal to fill a through hole of an electronic substrate. Because the leveling agent can be selectively adsorbed in an area with high current density, current density distribution on a cathode surface in an electroplating process is better adjusted. In addition, the leveling agent has convection dependence, and has high concentration in an area with high convection intensity. Finally, metal deposition in an area corresponding to high current density can be effectively suppressed, to obtain a uniform metal plated layer. In this application, the electroplated composition including the leveling agent with the specific structure can implement simultaneous filling of through holes with different apertures, lower a copper-plated thickness and a dimple value, and improve electroplating uniformity of the entire electronic substrate. In this way, this facilitates manufacturing of a fine line, helps improve reliability of an electronic product, and better meets a manufacturing requirement of a high-density interconnected electronic substrate by using a simple process with low costs. In addition, a molecular structure of the leveling agent is stable, to facilitate a decrease in impurity content of the metal plated layer. In addition, the leveling agent may be prepared by using a simple raw material and process.

In an implementation of this application, the substituted or unsubstituted nitrogen-containing heterocyclic group includes any one of a substituted or unsubstituted pyrrole group, a substituted or unsubstituted imidazole group, a substituted or unsubstituted pyridine group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group. The substituted or unsubstituted bipyridine may be substituted or unsubstituted 2,2'-bipyridine, or may be substituted or unsubstituted terpyridine. The substituted or unsubstituted nitrogen-containing heterocyclic group is beneficial for the leveling agent to obtain good leveling performance.

In an implementation of this application, a substituted group in the substituted nitrogen-containing heterocyclic group may include one or more (two or more) of unsubstituted alkyl, haloalkanes, substituted or unsubstituted aryl, substituted or unsubstituted alkoxy, substituted or unsubstituted aryloxy, sulfur (=S), mercapto (-SH), hydroxyl (-OH), carboxyl (-COOH), amino (-NH₂), and amide (-CO-NH₂). The substituted group may be located on a nitrogen atom of a nitrogen heterocycle, or on a carbon atom of the nitrogen heterocycle. There may be one or more (two or more) substituted groups, and the plurality of substituted groups may be a same group or different groups. The unsubstituted alkyl and the haloalkanes may be haloalkanes or unsubstituted alkyl with carbon atom numbers ranging from 1 to 10 (for example, carbon atom numbers 1, 2, 3, 4, 5, 6, 7, 8, 9, and 10), and may be specifically, for example, may be methyl, ethyl, propyl, isopropyl, butyl, or tertbutyl substituted or unsubstituted by halogen. The substituted or unsubstituted aryl may be substituted or unsubstituted aryl with carbon atom numbers ranging from 6 to 20 (for example, carbon atom numbers 6, 7, 8, 9, 10, 11, 12, 13, 14, 15, 16, 17, 18, 19 and 20), and may be specifically, for example, substituted or unsubstituted phenyl, naphthyl, or biphenyl. A substituted group in the substituted aryl may be a halogen atom, alkyl, mercapto, hydroxyl, amino, or the like. The substituted or unsubstituted alkoxy may be substituted or unsubstituted alkoxy with carbon atom numbers 1 to 10 (for example, carbon atom numbers 1, 2, 3, 4, 5, 6, 7, 8, 9, and 10), and may be specifically, for example, substituted or unsubstituted methoxy, ethoxy, propoxy, isopropoxy, butoxy, or tert-butoxy. A substituted group in the substituted alkoxy may be a halogen atom, hydroxyl, amino, mercapto, or the like. The substituted or unsubstituted aryloxy may be substituted or unsubstituted aryloxy with carbon atom numbers ranging from 6 to 20 (for example, carbon atom numbers 6, 7, 8, 9, 10, 11, 12, 13, 14, 15, 16, 17, 18, 19 and 20), and may be specifically, for example, substituted or unsubstituted phenoxy. A substituted group in the substituted aryloxy may be a halogen atom, alkyl, mercapto, hydroxyl, amino, or the like. The substituted sulfur group (=S) and the carbon atom on the heterocycle of the nitrogen-containing heterocyclic group form a C=S double bond. The halogen atom mentioned above may include a fluorine atom, a chlorine atom, a bromine atom, or an iodine atom.

In some implementations of this application, the substituted or unsubstituted nitrogen-containing heterocyclic group includes any one of a pyridine group, a 2,2'-bipyridine group, a terpyridine group, a 2,2'-bipyridine group substituted by methoxy, a 2,2'-bipyridine group substituted by hydroxyl, a 2,2'-bipyridine group substituted by carboxyl, a 2,2'-bipyridine group substituted by hydroxymethyl, a pyridine group substituted by amino, a 2,2'-bipyridine group substituted by tertbutyl, a pyrimidine group, an isoquinoline group, an imidazole group, an imidazole group substituted by methyl, an imidazole group substituted by amino, an imidazole group substituted by phenyl, an imidazole group substituted by amide, an imidazole group substituted by normal butyl, an imidazole group substituted by methyl, a benzimidazole group substituted by methoxy, a benzimidazole group, a benzimidazole group substituted by amino, a pyrimidine group substituted by hydroxyl, a pyrimidine group substituted by methyl, a pyrimidine group substituted by amino, a benzotriazole group, a triazole group, a triazole group substituted by methyl, a triazole group substituted by phenyl, a tetrazole group, a tetrazole group substituted by methyl, a tetrazole group substituted by phenyl, a triazobenzene group, a thiozole group, a benzothiazole group.

In some implementations of this application, the two pieces of R₁ may be a same substituted or unsubstituted nitrogen-containing heterocyclic group. In some implementations of this application, the two pieces of R₁ may be different substituted or unsubstituted nitrogen-containing heterocyclic groups. When the two pieces of R₁ are the same substituted or unsubstituted nitrogen-containing heterocyclic group, types of raw materials for preparing the leveling agent can be reduced, and a preparation process of the leveling agent can be more easily controlled.

In an implementation of this application, the two pieces of R₂ are independently substituted or unsubstituted chain alkylene with carbon atom numbers ranging from 2 to 10 (for example, carbon atom numbers 2, 3, 4, 5, 6, 7, 8, 9, and 10). An appropriate quantity of carbon atoms can enable the leveling agent to have good water solubility. The two pieces of R₂ may be same or different substituted or unsubstituted chain alkylene. In some implementations of this application, the two pieces of R₂ may be same substituted or unsubstituted chain alkylene. In some implementations of this application, the two pieces of R₂ may be different substituted or unsubstituted chain alkylene. The chain alkylene may be of a linear chain structure or a branched chain structure. Specifically, the substituted or unsubstituted chain alkylene may be substituted or unsubstituted ethyl, propyl, isopropyl, butyl, isobutyl, pentyl, hexyl, or the like. In an implementation of this application, the substituted chain alkylene may be chain alkylene substituted by hydroxyl. In some embodiments, the two pieces of R₂ are a same group. For example, the two pieces of R₂ are both ethyl, propyl, or the like. The two pieces of R₂ are a same group, to facilitate preparation of the leveling agent.

In an implementation of this application, in Formula (I), n may be an integer greater than or equal to 1. In some embodiments, n may be an integer ranging from 1 to 10. In other words, n may be 1, 2, 3, 4, 5, 6, 7, 8, 9, or 10. A larger value of n indicates a longer ether oxygen molecule chain, stronger suppression effect on the electroplated metal, and better leveling performance of the leveling agent. An appropriate value range of n may enable the leveling agent to balance leveling performance and dissolution performance.

In an implementation of this application, the two pieces of R₃ are independently substituted or unsubstituted chain alkylene with carbon atom numbers ranging from 2 to 10 (for example, carbon atom numbers 2, 3, 4, 5, 6, 7, 8, 9, and 10). The two pieces of R₃ may be same or different substituted or unsubstituted chain alkylene. The chain alkylene may be of a linear chain structure or a branched chain structure. Specifically, the substituted or unsubstituted chain alkylene may be substituted or unsubstituted ethyl, propyl, isopropyl, butyl, isobutyl, pentyl, hexyl, or the like. In an implementation of this application, the substituted chain alkylene includes chain alkylene substituted by hydroxyl, for example, propylidene substituted by hydroxyl.

In an implementation of this application, in Formula (I), m may be 0 or 1. When m is 0, the leveling agent has a structure formula shown in Formula (Ia): R₁-S-(R₂-O)ₙ-R₂-S-R₁ Formula (Ia). When m is 1, the leveling agent has a structure formula shown in Formula (Ib): R₁-S-R₃-O-(R₂-O)ₙ-R₂-O-R₃-S-R₁ Formula (Ib). When m is 0, a preparation process of the leveling agent may be simpler.

In an implementation of this application, in the electroplated composition, concentration of the leveling agent may range from 0.01 ppm to 1000 ppm. In some embodiments, the concentration of the leveling agent ranges from 0.1 ppm to 500 ppm. In some embodiments, the concentration of the leveling agent ranges from 0.2 ppm to 100 ppm. In some embodiments, the concentration of the leveling agent ranges from 1 ppm to 50 ppm. Specifically, in some embodiments, the concentration of the leveling agent may be 1 ppm, 2 ppm, 5 ppm, 8 ppm, 10 ppm, 12 ppm, 15 ppm, 18 ppm, 20 ppm, 25 ppm, 30 ppm, 40 ppm, 50 ppm, 60 ppm, 70 ppm, 80 ppm, 90 ppm, or 100 ppm. The concentration of the leveling agent in the electroplated composition is controlled to be within a proper range, to help obtain a moderate deposition speed, better implement simultaneous filling of through holes with different apertures, lower a thickness of a surface metal layer and a dimple value, and improve electroplating uniformity of the entire electronic substrate. In this way, this facilitates manufacturing of the fine line, and helps improve reliability of the electronic product.

In an implementation of this application, the electroplated composition may further include one or more of an accelerator, an inhibitor, and an inorganic additive. The leveling agent, the accelerator, the inhibitor, and the inorganic additive cooperate with each other, to better fill the through holes with different apertures simultaneously, and lower the thickness of the surface metal layer and the dimple value.

In an implementation of this application, the accelerator includes but is not limited to one or more of sodium 3-mercapto-1-propanesulfonate (MPS), sodium polyanethol sulfonate (SPS), and N,N-dimethyl-dithioformamide sodium propylene sulfonate (DPS). The addition of the accelerator can achieve depolarization effect, to accelerate metal deposition and refine grains at the metal layer. In an implementation of this application, in the electroplated composition, concentration of the accelerator may range from 0.01 ppm to 500 ppm. In some implementations, in the electroplated composition, the concentration of the accelerator may range from 0.05 ppm to 100 ppm. In some implementations, in the electroplated composition, the concentration of the accelerator may range from 0.2 ppm to 50 ppm. In some implementations, in the electroplated composition, the concentration of the accelerator may range from 0.5 ppm to 20 ppm. In some implementations, in the electroplated composition, the concentration of the accelerator may range from 1 ppm to 10 ppm.

In an implementation of this application, the inhibitor includes but is not limited to one or more of polyethylene glycol (PEG), polypropylene glycol (PPG), a block copolymer PEO-PPO-PEO (polyethylene oxide-polypropylene oxide-polyethylene oxide), a block copolymer PPO-PEO-PPO (polypropylene oxide-polyethylene oxide-polypropylene oxide), a random copolymer of ethylene oxide (EO) and propylene oxide (PO), and propylene glycol block polyether. The addition of the inhibitor can inhibit a growth rate of surface metal, and help obtain a thin surface metal layer after electroplating is completed. In an implementation of this application, concentration of the inhibitor in the electroplated composition may range from 1 ppm to 2000 ppm In some implementations, the concentration of the inhibitor in the electroplated composition ranges from 10 ppm to 1000 ppm. In some implementations, the concentration of the inhibitor in the electroplated composition ranges from 20 ppm to 500 ppm. In some implementations, the concentration of the inhibitor in the electroplated composition ranges from 50 ppm to 300 ppm. In some implementations, the concentration of the inhibitor in the electroplated composition ranges from 100 ppm to 200 ppm.

In an implementation of this application, the inorganic additive includes a chlorine anion, and concentration of the chlorine anion in the electroplated composition ranges from 0.1 ppm to 100 ppm. In some implementations, in the electroplated composition, the concentration of the chlorine anion may range from 0.1 ppm, 1 ppm, 5 ppm, 10 ppm, 20 ppm, 30 ppm, 40 ppm, 50 ppm, 60 ppm, 70 ppm, 80 ppm, 90 ppm, or 100 ppm. The addition of the chloride ion can make plated crystal dense and fine.

In an implementation of this application, the metal ion source includes any one of a copper ion source, a nickel ion source, a tin ion source, a cobalt ion source, a ruthenium ion source, and a silver ion source. It may be understood that, if a metal layer is pre-deposited, the metal ion source in the electroplated composition correspondingly includes a metal ion source corresponding to a metal element at the pre-deposited metal layer. For example, if a metal copper layer is pre-deposited, the metal ion source includes a copper ion source.

In an implementation of this application, the copper ion source includes one or more of copper sulfate pentahydrate and copper methane sulfonate. Electroplating is performed by using an acid system of the copper ion source, so that current efficiency is high, the solutions are environment-friendly, and the blind via hole can be better filled through cooperation of various additives. In an implementation of this application, in terms of copper ions, concentration of the copper ion source in the electroplated composition ranges from 1 g/L to 120 g/L . In some implementations, the concentration of the copper ion source in the electroplated composition may be specifically, for example, 1 g/L, 10 g/L, 20 g/L, 30 g/L, 40 g/L, 50 g/L, 60 g/L, 70 g/L, 80 g/L, 90 g/L, 100 g/L, 110 g/L, or 120 g/L per copper ion. The concentration of the copper ion source is controlled within a proper range, to help balance a deposition speed and brightness and flatness of the obtained copper plated layer.

In an implementation of this application, at least one acid includes one or more of sulphuric acid and methanesulfonic acid. In an implementation of this application, concentration of the at least one acid in the electroplated composition ranges from 1 g/L to 300 g/L. In some implementations, the concentration of the at least one acid in the electroplated composition may be specifically, for example, 1 g/L, 10 g/L, 20 g/L, 30 g/L, 40 g/L, 50 g/L, 55 g/L, 60 g/L, 70 g/L, 80 g/L, 100 g/L, 120 g/L, 150 g/L, 180 g/L, 200 g/L, 220 g/L, 250 g/L, or 300 g/L. A proper acid system and proper acid concentration help obtain a proper electroplating deposition rate.

An embodiment of this application further provides a leveling agent. The leveling agent has a general structure formula shown in Formula (II):

R₁-S-(R₃-O)ₘ-(R₂-O)ₙ-R₂-(O-R₃)ₘ-S-R₁ Formula (II),

where
in Formula (II), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2;
when m=0, the substituted or unsubstituted nitrogen-containing heterocyclic group includes any one of a substituted or unsubstituted pyrrole group, a substituted or unsubstituted pyrimidine group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group;
when m=1, the substituted or unsubstituted nitrogen-containing heterocyclic group includes any one of a substituted or unsubstituted pyrrole group, a substituted or unsubstituted imidazole group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group; and
a substituted group in the substituted nitrogen-containing heterocyclic group includes one or more of unsubstituted alkyl, haloalkanes, substituted or unsubstituted alkoxy, substituted or unsubstituted aryloxy, sulfur, mercapto, hydroxyl, carboxyl, amino, and amide.

In Formula (II), for selection of various substituted or unsubstituted nitrogen-containing heterocyclic groups involved in the two pieces of R₁, refer to a selection range of the two pieces of R₁ in the leveling agent with the general structure formula shown in Formula (I) above. For selection of the two pieces of R₂ and the two pieces of R₃, refer to a selection range of the two pieces of R₂ and the two pieces of R₃ in the leveling agent with the general structure formula shown in Formula (I) above. Details are not described herein again.

The leveling agent provided in embodiments of this application has an ether oxygen chain: (R₃-O)ₘ-(R₂-O)ₙ-R₂-(O-R₃)ₘ and the nitrogen-containing heterocyclic groups connected to two ends of the ether oxygen chain via sulfur bonds. The leveling agent with the specific structure is prepared into an electroplating solution that is used as electroplated metal to fill a through hole of an electronic substrate. Because the leveling agent can be selectively adsorbed in an area with high current density, current density distribution on a cathode surface in an electroplating process is better adjusted. In addition, the leveling agent has convection dependence, and has high concentration in an area with high convection intensity. Finally, metal deposition in an area corresponding to high current density can be effectively suppressed, to obtain a uniform metal plated layer. The electroplating solution including the leveling agent with the specific structure in this application can implement simultaneous filling of through holes with different apertures, lower a copper-plated thickness and a dimple value, and improve electroplating uniformity of the entire electronic substrate. In this way, this facilitates manufacturing of a fine line, helps improve reliability of an electronic product, and better meets a manufacturing requirement of a high-density interconnected electronic substrate by using a simple process with low costs. In addition, a molecular structure of the leveling agent provided in embodiments of this application is stable, to facilitate a decrease in impurity content of the metal plated layer. The leveling agent provided in embodiments of this application may be prepared by using a simple raw material and process.

Correspondingly, an embodiment of this application further provides a preparation method for a leveling agent. The method includes:
substituting a p-toluene sulfonyl group or an epoxy group for a compound A: OH-(R₂-O)ₙ-R₂-OH, and then reacting, by the compound A, with a nitrogen-containing heterocyclic compound containing mercapto or a carbon-sulfur double bond, to obtain the leveling agent shown in Formula (II), where in the compound A, two pieces of R₂ are independently substituted or unsubstituted chain alkylene, and n is an integer greater than or equal to 1.

It may be understood that group selection of R₂ in the compound A and a value of n are consistent with group selection of R₂ in the molecular structure of the leveling agent shown in Formula (II) and the value of n. In other words, selection of the compound A determines a partial molecular structure of the leveling agent. For group selection of R₂ in the compound A and the value of n, refer to group selection of R₂ in the molecular structure of the leveling agent shown in Formula (I) and the value of n. Details are not described herein again.

In an implementation of this application, for example, R₂ is isopropyl, n is 3, and the compound A is tripropylene glycol.

In an implementation of this application, for example, R₂ is ethyl, n is 3, and the compound A is triethylene glycol (HO-CH₂-CH₂-O-CH₂-CH₂-O-CH₂-CH₂-O-CH₂-CH₂-OH). For example, a process of preparing the leveling agent by using triethylene glycol as a raw material may be as follows: Triethylene glycol first reacts with toluenesulfonyl chloride, and then reacts with 1,5-mercapto-1-methyltetrazole, to obtain the leveling agent.

In an implementation of this application, a temperature of the first reaction may range from 50°C to 90°C, and time may range from 10 h to 36 h. A temperature of the second reaction may range from 50°C to 90°C, and time may range from 10 h to 36 h.

An embodiment of this application further provides an electroplated composition. The electroplated composition includes the leveling agent with the general structure formula shown in Formula (II) in embodiments of this application. Concentration of the leveling agent, another component, and content in the electroplated composition are consistent with those in the foregoing electroplated composition. Details are not described herein again.

An embodiment of this application further provides application of the leveling agent and/or the electroplated composition in a metal electroplating process. In the application, the electroplated metal may include any one of electroplated copper and copper alloy, electroplated nickel and nickel alloy, electroplated tin and tin alloy, electroplated cobalt and cobalt alloy, electroplated ruthenium and ruthenium alloy, and electroplated silver and silver alloy.

In an implementation of this application, the electroplated metal includes electroplated metal in a printed circuit board preparation process, electroplated metal in an integrated circuit metal interconnection process, or electroplated metal in an electronic packaging process. Specifically, the electroplated metal may be electroplated metal in processes such as through silicon via filling, substrate redistribution, under-bump metallization, and through hole filling.

In an implementation of this application, the electroplated metal includes super-filled metal filled in a through hole on an electronic substrate through electroplating. The electronic substrate may be a common substrate, a printed circuit board, a package substrate, or the like. The through hole may include a plated through hole, a blind via hole, and a buried via hole. super-filled metal filling may be filling electroplated copper and copper alloy, electroplated nickel and nickel alloy, electroplated tin and tin alloy, electroplated cobalt and cobalt alloy, electroplated ruthenium and ruthenium alloy, or electroplated silver and silver alloy.

The leveling agent and the electroplated composition provided in embodiments of this application are used to perform metal electroplating to fill the through hole on the electronic substrate, to implement simultaneous filling of through holes with different apertures, lower a thickness of a surface metal layer and a dimple value, and improve electroplating uniformity of the entire electronic substrate. In this way, this facilitates manufacturing of a fine line, helps improve reliability of an electronic product, and better meets a manufacturing requirement of a high-density interconnected electronic substrate by using a simple process with low costs.

An embodiment of this application further provides a metal electroplating method, including the following steps:
contacting a to-be-electroplated substrate with the electroplated composition provided in embodiments of this application, and applying a current to the to-be-electroplated substrate for electroplating, so that a metal layer is formed on the to-be-electroplated substrate.

Specifically, the to-be-electroplated substrate may be immersed into the electroplated composition as a cathode, and the electroplated composition, namely, an electroplating solution, is used as an electrolyte to form a conductive loop together with a soluble or insoluble anode, to implement metal deposition on the to-be-electroplated substrate.

In an implementation of this application, the to-be-electroplated substrate is provided with a through hole, and the metal layer includes an intra-hole filling layer filling the through hole and a surface deposition layer deposited around the through hole. The through hole may include one or more of a plated through hole, a blind via hole, and a buried via hole.

In an implementation of this application, a diameter of the through hole may range from 10 µm to 200 µm, and a depth may range from 20 µm to 200 µm. Specifically, the diameter of the through hole may be, for example, 10 µm, 20 µm, 30 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, or 200 µm. The depth of the through hole may be, for example, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, or 200 µm. The to-be-electroplated substrate may have through holes with different diameters and depths.

In an implementation of this application, a process condition of the electroplating may be as follows: an electroplating temperature ranges from 10°C to 40°C, a current density ranges from 0.5 ASD to 5 ASD, and electroplating time ranges from 30 min to 300 min. In some implementations, the electroplating temperature is 10°C, 20°C, 25°C, 30°C, or 40°C, the current density is 0.5 ASD, 1 ASD, 1.5 ASD, 2 ASD, 2.5 ASD, 3 ASD, 4 ASD, or 5 ASD, and the electroplating time is 30 min, 60 min, 90 min, 120 min, 150 min, 180 min, 200 min, 250 min, or 300 min.

Usually, before electroplating, metallization processing is performed on a wall of the through hole. For example, a metal layer is chemically plated on the wall of the through hole to serve as a metal seed layer. For example, a copper seed layer is chemically plated on the wall of the through hole.

In an implementation of this application, after the metal layer is formed through electroplating, a process like chemical mechanical planarization may be used to smooth the metal layer, or planarization may be used to remove a surface deposition layer. Because a surface deposition layer, with a smooth surface and a thin thickness, on the electroplated composition in this application can be obtained, difficulty of a subsequent planarization process can be reduced.

Refer to FIG. 4. An embodiment of this application further provides an electronic substrate 100, including a substrate layer 101 and a metal layer 102 disposed at the substrate layer. The metal layer 102 is formed by electroplating the electroplated composition in embodiments of this application, or formed by using the metal electroplating method in embodiments of this application.

In an implementation of this application, the metal layer 102 includes any one of a copper or copper alloy layer, a nickel or nickel alloy layer, a tin or tin alloy layer, a cobalt or cobalt alloy layer, a ruthenium or ruthenium alloy layer, and a silver or silver alloy layer.

In an implementation of this application, the substrate layer 101 is provided with a through hole 10, and the metal layer 102 includes an intra-hole filling layer 1021 filling the through hole 10 and a surface deposition layer 1022 deposited around the through hole 10.

In an implementation of this application, a chemically -plated metal seed layer 103, for example, a copper seed layer, formed by performing metallization processing on the through hole 10 is further included between the substrate layer 101 and the metal layer 102.

In an implementation of this application, a diameter of the through hole 10 may range from 10 µm to 200 µm, and a depth may range from 20 µm to 200 µm. In an implementation of this application, a diameter of the through hole 10 may range from 10 µm to 200 µm, and a depth may range from 20 µm to 200 µm. Specifically, the diameter of the through hole 10 may be, for example, 10 µm, 20 µm, 30 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, or 200 µm. The depth of the through hole 10 may be, for example, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, or 200 µm. The substrate layer 101 may be provided with a plurality of through holes 10, and the plurality of through holes 10 may have different diameters and depths, or may have a same diameter and depth.

In an implementation of this application, the leveling agent may obtain a low dimple value while maintaining a low thickness of the surface deposition layer. In some embodiments, the leveling agent may implement that the thickness of the surface deposition layer 1022 is less than 18 µm, an absolute value of the dimple value of the intra-hole filling layer 1021 is less than 5 µm. In some embodiments, the thickness of the surface deposition layer 1022 is less than 17 µm. In some embodiments, the thickness of the surface deposition layer 1022 is less than 16 µm. In some embodiments, the thickness of the surface deposition layer 1022 is less than 15 µm. In some embodiments, the absolute value of the dimple value of the intra-hole filling layer 1021 is less than 5 µm. In some embodiments, the absolute value of the dimple value of the intra-hole filling layer 1021 is less than or equal to 4 µm. In some embodiments, the absolute value of the dimple value of the intra-hole filling layer 1021 is less than or equal to 3 µm.

It may be understood that, during actual semiconductor application, a process like chemical mechanical planarization may be used to smooth the metal layer 102, or planarization may be used to remove the surface deposition layer 1022.

An embodiment of this application further provides an electronic apparatus. The electronic apparatus uses the electronic substrate 100 in embodiments of this application.

Embodiments of this application are further described below by using a plurality of embodiments.

### Embodiment 1

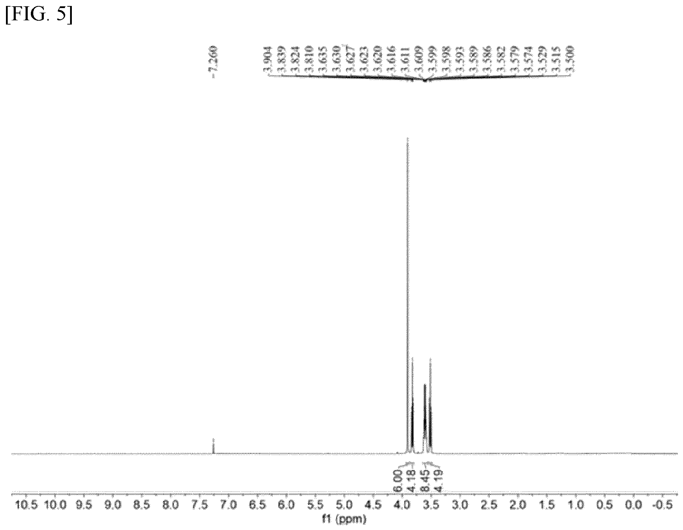

Triethylene glycol, triethylamine, N'N-dimethylaminopyridine, and dichloromethane are sequentially added to a round-bottom flask to stir for 5 min. Then, toluenesulfonyl chloride is added to react at a temperature of 50°C to 90°C, to obtain an intermediate through the reaction. After the intermediate, 5-mercapto-1-methyltetrazole, and acetonitrile are stirred and react with each other at a temperature of 50°C to 90°C, a rotary evaporator is used to remove solvents, and a column chromatographic column is used for purifying, to obtain a leveling agent 1. FIG. 5 shows a hydrogen nuclear magnetic resonance spectrum of the prepared leveling agent 1 according to Embodiment 1 of this application.

A copper electroplating solution includes components of the following mass formulas:
copper sulfate pentahydrate: 220 g/L (in a unit of copper sulfate pentahydrate);
sulfate: 55 g/L;
chlorine ions: 60 ppm;
the leveling agent 1: 10 ppm;
an accelerator: 1 ppm; and
an inhibitor: 100 ppm.

The copper electroplating solution in Embodiment 1 is used to fill the blind via hole through electroplating, where an electroplating temperature is a normal temperature, a current density is 1.5 ASD, and electroplating time is 90 min.

### Embodiment 2

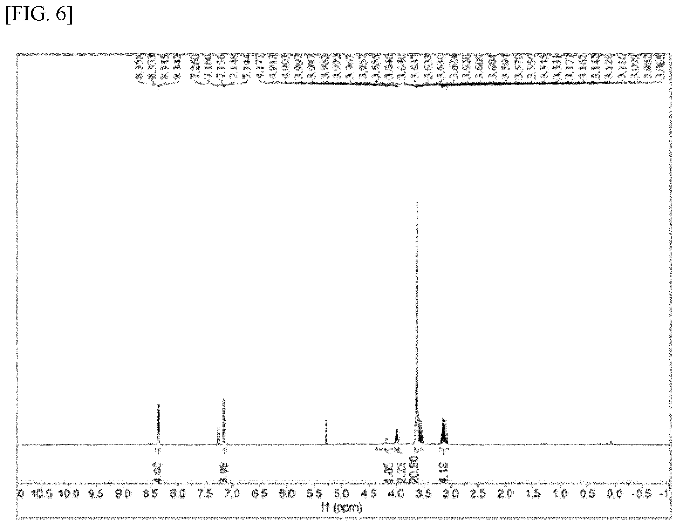

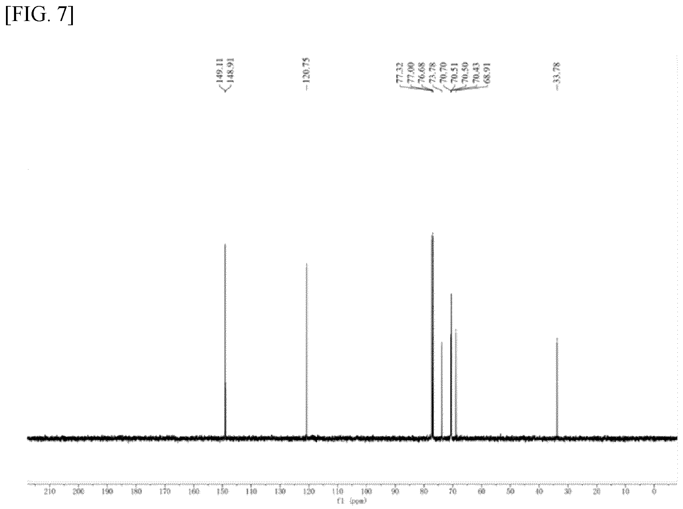

Triethylene glycol, epichlorohydrin, sodium hydroxide, tetrabutylammonium fluoride, and water are sequentially added to a round-bottom flask and mixed to react with each other, to obtain an intermediate. The obtained intermediate, 4-mercaptopyridine, and isopropyl alcohol are sequentially added to a round-bottom flask including a magnetic stirrer. After the mixed system is heated and vapors return, purification is performed by using column chromatography, to obtain a leveling agent 2. FIG. 6 shows a hydrogen nuclear magnetic resonance spectrum of the prepared leveling agent 1 according to Embodiment 1 of this application. FIG. 7 shows a carbon nuclear magnetic resonance spectrum of the prepared leveling agent 1 according to Embodiment 1 of this application.

A copper electroplating solution includes components of the following mass formulas:
copper sulfate pentahydrate: 220 g/L (in a unit of copper sulfate pentahydrate);
sulfate: 55 g/L;
chlorine ions: 60 ppm;
the leveling agent 2: 10 ppm;
an accelerator: 1 ppm; and
an inhibitor: 100 ppm.

The copper electroplating solution in Embodiment 2 is used to fill the blind via hole through electroplating, where an electroplating temperature is a normal temperature, a current density is 1.5 ASD, and electroplating time is 60 min.

### Comparative example 1

A copper electroplating solution includes components of the following mass formulas:
copper sulfate pentahydrate: 220 g/L (in a unit of copper sulfate pentahydrate);
sulfate: 55 g/L;
chlorine ions: 60 ppm;
an accelerator: 1 ppm; and
an inhibitor: 100 ppm.

The copper electroplating solution in the comparative example 1 is used to fill the blind via hole through electroplating, where an electroplating temperature is a normal temperature, a current density is 1.5 ASD, and electroplating time is 60 min.

### Comparative example 2

A copper electroplating solution includes components of the following mass formulas:
copper sulfate pentahydrate: 220 g/L (in a unit of copper sulfate pentahydrate);
sulfate: 55 g/L;
chlorine ions: 60 ppm;
the leveling agent 3: 10 ppm;
an accelerator: 1 ppm; and
an inhibitor: 100 ppm.

The leveling agent 3 is an N-heterocyclic leveling agent that is commonly used in the conventional technology and that has a structure different from that of the leveling agent in embodiments of this application. The copper electroplating solution in the comparative example 2 is used to fill the blind via hole through electroplating, where an electroplating temperature is a normal temperature, a current density is 1.5 ASD, and electroplating time is 90 min.

### Comparative example 3

A copper electroplating solution includes components of the following mass formulas:
copper sulfate pentahydrate: 220 g/L (in a unit of copper sulfate pentahydrate);
sulfate: 55 g/L;
chlorine ions: 60 ppm;
the leveling agent 4: 10 ppm;
an accelerator: 1 ppm; and
an inhibitor: 100 ppm.

The leveling agent 4 is another N-heterocyclic leveling agent that is commonly used in the conventional technology and that has a structure different from that of the leveling agent in embodiments of this application. The copper electroplating solution in the comparative example 3 is used to fill the blind via hole through electroplating, where an electroplating temperature is a normal temperature, a current density is 1.5 ASD, and electroplating time is 60 min.

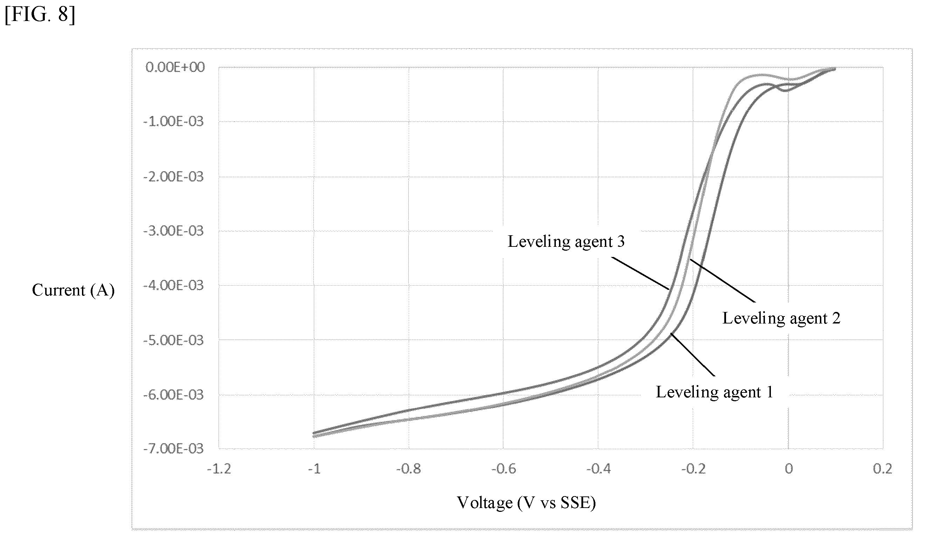

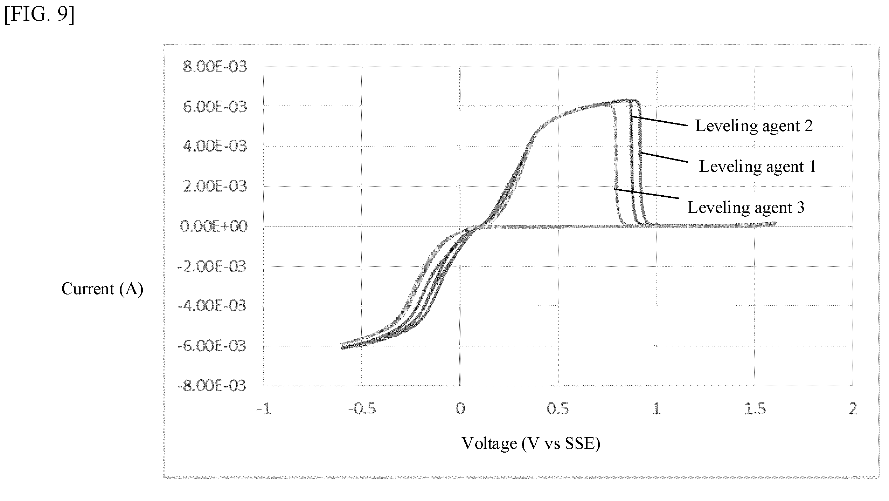

FIG. 8 is linear sweep voltammetry curves of the leveling agent 1, the leveling agent 2, and the leveling agent 3. It can be learned from FIG. 8 that in a region of a sedimentation potential -0.6 V vs. SSE (mercury/mercury sulfate electrode), polarization capabilities of the leveling agent 1 and the leveling agent 2 are obviously stronger than a polarization capability of the leveling agent 3. FIG. 9 shows cyclic voltammetry curves of the leveling agent 1, the leveling agent 2, and the leveling agent 3. It can be learned from FIG. 9 that only the leveling agent 1 and the leveling agent 2 have hysteresis loops, which indicates the leveling agent 1 and the leveling agent 2 have stronger filling capabilities.

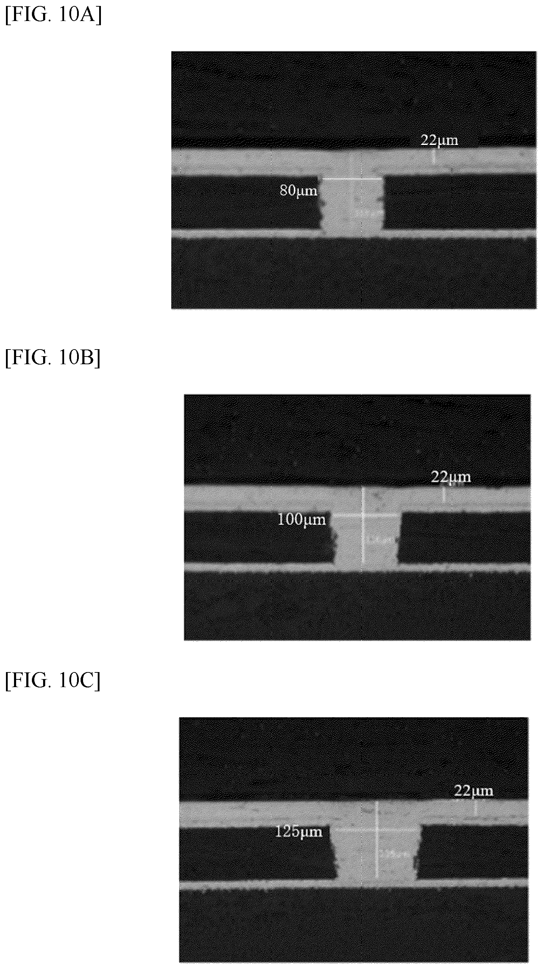

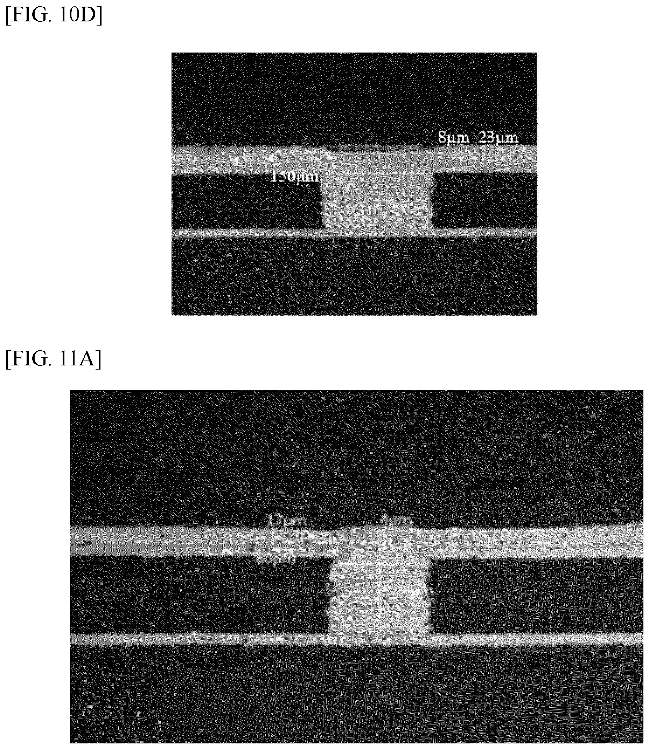

FIG. 10A, FIG. 10B, FIG. 10C, and FIG. 10D respectively show results of filling, through electroplating, blind via holes with apertures of 80 µm, 100 µm, 125 µm, and 150 µm by using the copper electroplating solution in Embodiment 1. FIG. 10A shows the result of filling, through electroplating, the blind via hole with the aperture of 80 µm. FIG. 10B shows the result of filling, through electroplating, the blind via hole with the aperture of 100 µm. FIG. 10C shows the result of filling, through electroplating, the blind via hole with the aperture of 125 µm. FIG. 10D shows the result of filling, through electroplating, the blind via hole with the aperture of 150 µm. In FIG. 10A, FIG. 10B, and FIG. 10C, a thickness of a surface copper layer is 22 µm, and a dimple value is 0. In FIG. 10D, a thickness of a surface copper layer is 23 µm, and a dimple value is 8 µm.

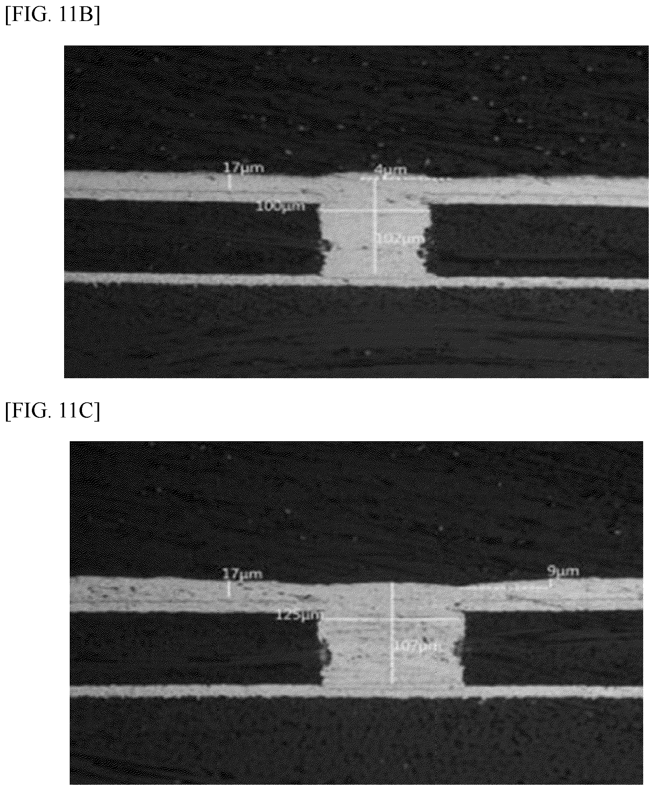

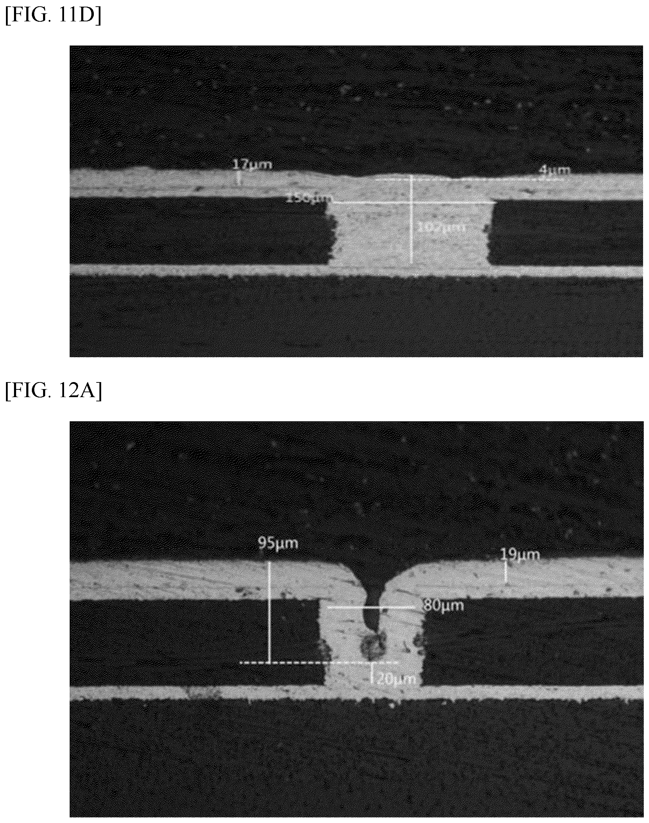

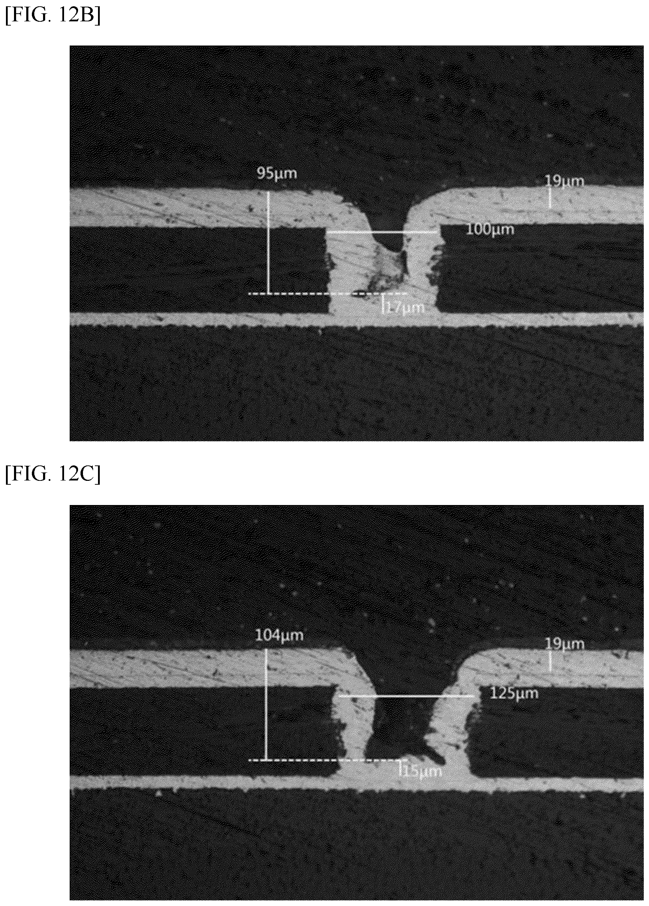

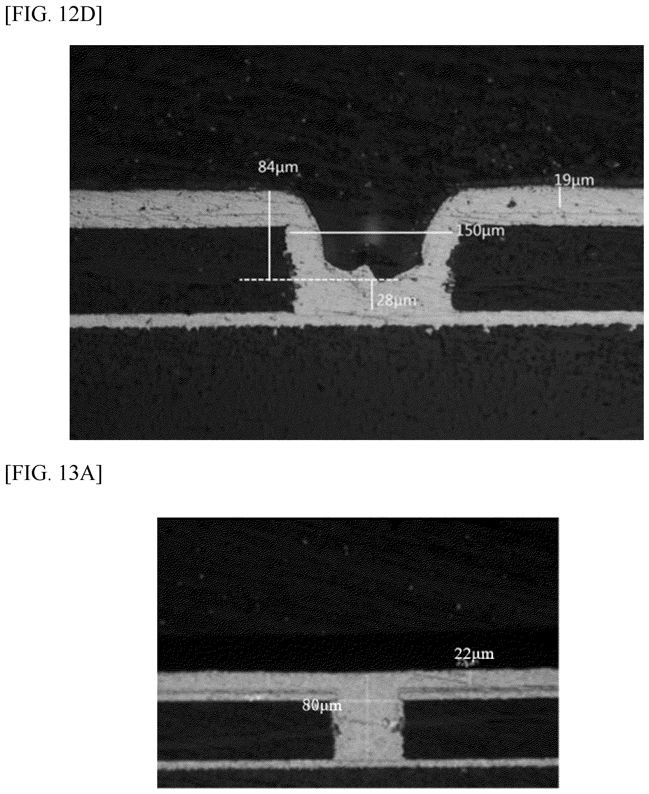

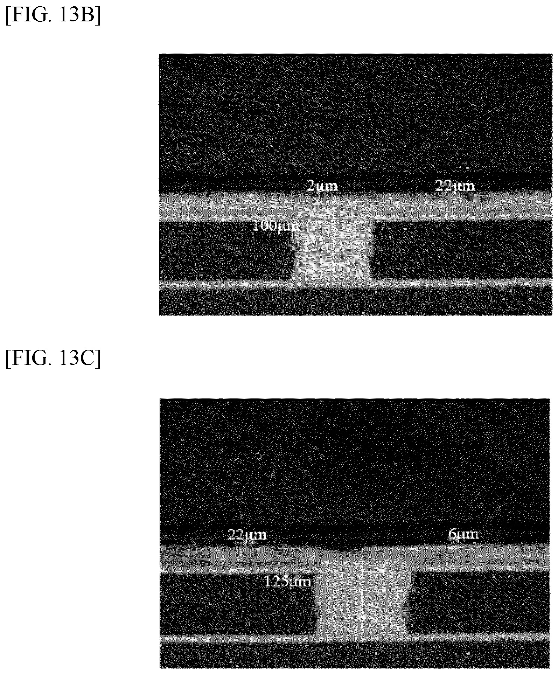

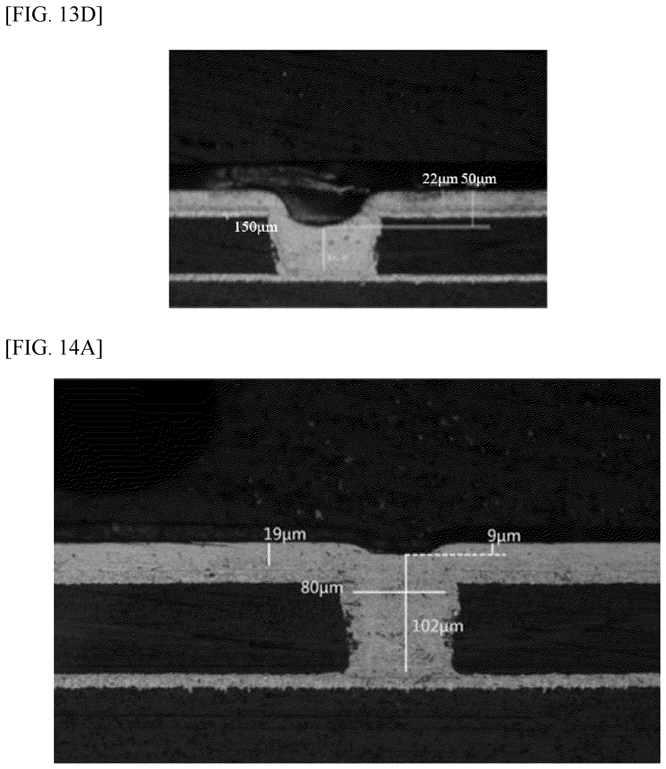

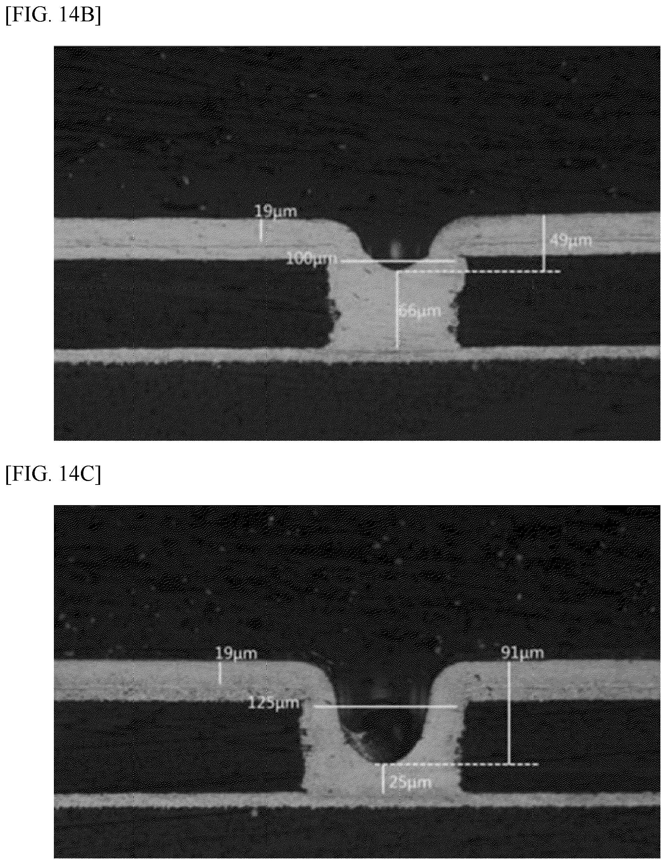

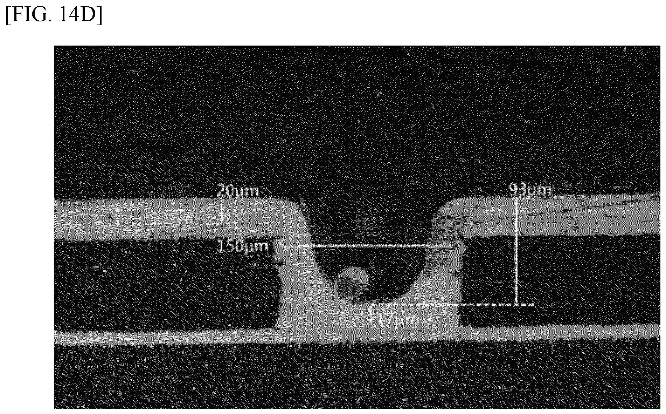

FIG. 11A, FIG. 11B, FIG. 11C, and FIG. 11D respectively show results of filling, through electroplating, blind via holes with apertures of 80 µm, 100 µm, 125 µm, and 150 µm by using the copper electroplating solution in Embodiment 2. FIG. 11A shows the result of filling, through electroplating, the blind via hole with the aperture of 80 µm. FIG. 11B shows the result of filling, through electroplating, the blind via hole with the aperture of 100 µm. FIG. 11C shows the result of filling, through electroplating, the blind via hole with the aperture of 125 µm. FIG. 11D shows the result of filling, through electroplating, the blind via hole with the aperture of 150 µm. In FIG. 11A, FIG. 11B, FIG. 11C, and FIG. 11D, a thickness of a surface copper layer is 17 µm, and dimple values are respectively 4 µm, 4 µm, 9 µm, and 4 µm. FIG. 12A, FIG. 12B, FIG. 12C, and FIG. 12D respectively show results of filling, through electroplating, blind via holes with apertures of 80 µm, 100 µm, 125 µm, and 150 µm by using the copper electroplating solution in the comparative example 1. In FIG. 12A, FIG. 12B, FIG. 12C, and FIG. 12D, a thickness of a surface copper layer is 19 µm, and dimple values are respectively 95 µm, 95 µm, 104 µm, and 84 µm. FIG. 13A, FIG. 13B, FIG. 13C, and FIG. 13D respectively show results of filling, through electroplating, blind via holes with apertures of 80 µm, 100 µm, 125 µm, and 150 µm by using the copper electroplating solution in the comparative example 2. In FIG. 13A, FIG. 13B, FIG. 13C, and FIG. 13D, a thickness of a surface copper layer is 22 µm, and dimple values are respectively 0 µm, 2 µm, 6 µm, and 50 µm. FIG. 14A, FIG. 14B, FIG. 14C, and FIG. 14D respectively show results of filling, through electroplating, blind via holes with apertures of 80 µm, 100 µm, 125 µm, and 150 µm by using the copper electroplating solution in the comparative example 3. In FIG. 14A, FIG. 14B, FIG. 14C, and FIG. 14D, thicknesses of surface copper layers are respectively 19 µm, 19 µm, 19 µm, and 20 µm, and dimple values are respectively 9 µm, 49 µm, 91 µm, and 93 µm.

It can be learned from the electroplating results in Embodiment 1 and Embodiment 2 and comparative examples 1 to 3 that, in comparison with the comparative example 1 in which no leveling agent is added, in Embodiment 1 and Embodiment 2 of this application, the addition of the leveling agent greatly reduces a dimple value (dimple) of blind via hole filling, where the dimple value is less than 10 µm. In addition, in filling time of 60 min and 90 min, in embodiments of this application, the leveling agent 1 and the leveling agent 2 may be used to completely fill blind via holes with different apertures of 80 µm to 150 µm at the same time, and lower a copper-plated thickness. However, when a common leveling agent is used in the comparative example 2 and the comparative example 3, it is difficult to simultaneously fill the 80 µm small hole and the 150 µm large hole while maintaining a low dimple value.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate the following three cases: Only A exists, both A and B exist, and only B exists, where A and B may be singular or plural. The character "/" usually indicates an "or" relationship between the associated objects.

In this application, "at least one" means one or more, and "a plurality of" means two or more. At least one of the following items (pieces) or a similar expression thereof refers to any combination of these items, including any combination of singular items (pieces) or plural items (pieces). For example, "at least one of a, b, or c", or "at least one of a, b, and c" may indicate: a, b, c, a-b (namely, a and b), a-c, b-c, or a-b-c, where a, b, and c may be singular or plural.

The foregoing descriptions are merely specific implementations of this application, but the protection scope of this application is not limited thereto. Any variation or replacement that can be readily figured out by a person skilled in the art within the technical scope disclosed in this application shall fall within the protection scope of this application. Therefore, the protection scope of this application shall be subject to the protection scope of the claims.

## Claims

1. A composition, wherein the composition comprises a metal ion source and a leveling agent shown in Formula (I):
R₁-S-(R₃-O)ₘ-(R₂-O)ₙ-R₂-(O-R₃)ₘ-S-R₁ Formula (I),
wherein
in Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2.

2. The composition according to claim 1, wherein the substituted or unsubstituted nitrogen-containing heterocyclic group comprises any one of a substituted or unsubstituted pyrrole group, a substituted or unsubstituted imidazole group, a substituted or unsubstituted pyridine group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group.

3. The composition according to claim 1 or 2, wherein a substituted group in the substituted nitrogen-containing heterocyclic group comprises one or more of unsubstituted alkyl, haloalkanes, substituted or unsubstituted aryl, substituted or unsubstituted alkoxy, substituted or unsubstituted aryloxy, sulfur, mercapto, hydroxyl, carboxyl, amino, and amide.

4. The composition according to any one of claims 1 to 3, wherein the two pieces of R₂ are independently substituted or unsubstituted chain alkylene with carbon atom numbers ranging from 2 to 10, and the two pieces of R₃ are independently substituted or unsubstituted chain alkylene with carbon atom numbers ranging from 2 to 10.

5. The composition according to any one of claims 1 to 4, wherein the substituted chain alkylene comprises chain alkylene substituted by hydroxyl.

6. The composition according to any one of claims 1 to 5, wherein in the composition, concentration of the leveling agent shown in Formula (I) ranges from 0.01 ppm to 1000 ppm.

7. The composition according to any one of claims 1 to 6, wherein the composition further comprises at least one acid, and the at least one acid comprises one or more of sulphuric acid and methanesulfonic acid.

8. The composition according to claim 7, wherein concentration of the at least one acid in the composition ranges from 1 g/L to 300 g/L.

9. The composition according to any one of claims 1 to 8, wherein the composition further comprises one or more of an accelerator, an inhibitor, and an inorganic additive.

10. The composition according to claim 9, wherein the accelerator comprises one or more of sodium 3-mercapto-1-propanesulfonate, sodium polyanethol sulfonate, and N,N-dimethyl-dithioformamide sodium propylene sulfonate, and concentration of the accelerator in the composition ranges from 0.01 ppm to 500 ppm.

11. The composition according to claim 9, wherein the inhibitor comprises one or more of polyethylene glycol, polypropylene glycol, a block copolymer PEO-PPO-PEO, a block copolymer PPO-PEO-PPO, a random copolymer of EO and PO, and propylene glycol block polyether, and concentration of the inhibitor in the composition ranges from 1 ppm to 2000 ppm.

12. The composition according to claim 9, wherein the inorganic additive comprises a chlorine anion, and concentration of the chlorine anion in the composition ranges from 0.1 ppm to 100 ppm.

13. The composition according to any one of claims 1 to 12, wherein the metal ion source comprises any one of a copper ion source, a nickel ion source, a tin ion source, a cobalt ion source, a ruthenium ion source, and a silver ion source.

14. The composition according to claim 13, wherein the copper ion source comprises one or more of copper sulfate pentahydrate and copper methane sulfonate, and in terms of copper ions, concentration of the copper ion source in the composition ranges from 1 g/L to 120 g/L .

15. Application of the composition according to any one of claims 1 to 14 to electroplated metal.

16. The application according to claim 15, wherein the electroplated metal comprises any one of electroplated copper and copper alloy, electroplated nickel and nickel alloy, electroplated tin and tin alloy, electroplated cobalt and cobalt alloy, electroplated ruthenium and ruthenium alloy, and electroplated silver and silver alloy.

17. The application according to claim 15 or 16, wherein the electroplated metal comprises metal electroplated in a through hole on an electronic substrate, to implement metal filling.

18. The application of the compound shown in Formula (I) to electroplating metal, wherein
R₁-S-(R₃-O)ₘ-(R₂-O)ₙ-R₂-(O-R₃)ₘ-S-R₁ Formula (I),
wherein
in Formula (I), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2.

19. A leveling agent, wherein the leveling agent has a general structure formula shown in Formula (II):
R₁-S-(R₃-O)ₘ-(R₂-O)ₙ-R₂-(O-R₃)ₘ-S-R₁ Formula (II),
wherein
in Formula (II), two pieces of R₁ are independently selected from a substituted or unsubstituted nitrogen-containing heterocyclic group, two pieces of R₂ are independently substituted or unsubstituted chain alkylene, two pieces of R₃ are independently substituted or unsubstituted chain alkylene, m is 0 or 1, and n is an integer greater than or equal to 2;
when m=0, the substituted or unsubstituted nitrogen-containing heterocyclic group comprises any one of a substituted or unsubstituted pyrrole group, a substituted or unsubstituted pyrimidine group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group;
when m=1, the substituted or unsubstituted nitrogen-containing heterocyclic group comprises any one of a substituted or unsubstituted pyrrole group, a substituted or unsubstituted imidazole group, a substituted or unsubstituted pyrimidine group, a substituted or unsubstituted triazole group, a substituted or unsubstituted tetrazole group, a substituted or unsubstituted thiozole group, a substituted or unsubstituted benzopyrrole group, a substituted or unsubstituted benzimidazole group, a substituted or unsubstituted benzopyridine group, a substituted or unsubstituted benzopyrimidine group, a substituted or unsubstituted benzotriazole group, a substituted or unsubstituted benzothiazole group, a substituted or unsubstituted bipyridine group, and a substituted or unsubstituted triazobenzene group; and
a substituted group in the substituted nitrogen-containing heterocyclic group comprises one or more of unsubstituted alkyl, haloalkanes, substituted or unsubstituted alkoxy, substituted or unsubstituted aryloxy, sulfur, mercapto, hydroxyl, carboxyl, amino, and amide.

20. The leveling agent according to claim 19, wherein the two pieces of R₂ are independently substituted or unsubstituted chain alkylene with carbon atom numbers ranging from 2 to 10, and the two pieces of R₃ are independently substituted or unsubstituted chain alkylene with carbon atom numbers ranging from 2 to 10.

21. The leveling agent according to claim 19 or 20, wherein the substituted chain alkylene comprises chain alkylene substituted by hydroxyl.

22. A preparation method for the leveling agent according to any one of claims 19 to 21, comprising:
substituting a p-toluene sulfonyl group or an epoxy group for a compound A: OH-(R₂-O)ₙ-R₂-OH, and then reacting, by the compound A, with a nitrogen-containing heterocyclic compound containing mercapto or a carbon-sulfur double bond, to obtain the leveling agent, wherein in the compound A, two pieces of R₂ are independently substituted or unsubstituted chain alkylene, and n is an integer greater than or equal to 2.

23. A composition, comprising the leveling agent according to any one of claims 19 to 22.

24. Application of the leveling agent according to any one of claims 19 to 22 or the composition according to claim 23 to electroplated metal.

25. The application according to claim 24, wherein the electroplated metal comprises any one of electroplated copper and copper alloy, electroplated nickel and nickel alloy, electroplated tin and tin alloy, electroplated cobalt and cobalt alloy, electroplated ruthenium and ruthenium alloy, and electroplated silver and silver alloy.

26. The application according to claim 24 or 25, wherein the electroplated metal comprises metal electroplated in a through hole on an electronic substrate, to implement metal filling.

27. A metal electroplating method, comprising the following steps:
contacting a to-be-electroplated substrate with the composition according to any one of claims 1 to 14 or the composition according to claim 23, and applying a current to the to-be-electroplated substrate for electroplating, so that a metal layer is formed on the to-be-electroplated substrate.

28. The method according to claim 27, wherein the to-be-electroplated substrate is provided with a through hole, and the metal layer comprises an intra-hole filling layer filling the through hole and a surface deposition layer deposited around the through hole.

29. The method according to claim 28, wherein a diameter of the through hole ranges from 10 µm to 200 µm, and a depth ranges from 20 µm to 200 µm.

30. The method according to any one of claims 27 to 29, wherein a process condition of the electroplating is as follows: an electroplating temperature ranges from 10°C to 40°C, a current density ranges from 0.5 ASD to 5 ASD, and electroplating time ranges from 30 min to 300 min.

31. An electronic substrate, comprising a substrate layer and a metal layer disposed at the substrate layer, wherein the metal layer is formed by electroplating the composition according to any one of claims 1 to 14 or the composition according to claim 23, or formed by using the metal electroplating method according to any one of claims 27 to 30.

32. An electronic apparatus, wherein the electronic apparatus uses the electronic substrate according to claim 31.
